# EUROPÄISCHE PATENTSCHRIFT

(11) **EP 1 175 815 B1**
(45) Veröffentlichungstag und Bekanntmachung des Hinweises auf die Patenterteilung: **06.10.2004**
(21) Anmeldenummer: 00938518.8
(22) Anmeldetag: 28.04.2000
(51) Int. Cl.: H05K 13/04

(54) **VERFAHREN UND VORRICHTUNG ZUM BESTÜCKEN VON SUBSTRATEN MIT BAUELEMENTEN**
METHOD AND DEVICE FOR PLACING COMPONENTS ON SUBSTRATES
PROCEDE ET DISPOSITIF POUR IMPLANTER DES COMPOSANTS SUR DES SUBSTRATS

(30) Priorität: 30.04.1999 DE 19919917
(43) Veröffentlichungstag der Anmeldung: 30.01.2002
(73) Patentinhaber: SIEMENS AKTIENGESELLSCHAFT, 80333 München (DE)
(72) Erfinder: GRASMÜLLER, Hans-Horst, D-82291 Mammendorf (DE); BACHTHALER, Thomas, D-82131 Stockdorf (DE); NUMBERGER, Richard, D-85464 Finsing (DE); BARNOWSKI, Frank, D-81371 München (DE)
(86) Internationale Anmeldenummer: PCT/DE2000/001352
(87) Internationale Veröffentlichungsnummer: WO 2000/067543

(56) Entgegenhaltungen:
- US-A- 5 422 554
- US-A- 5 535 873

## Beschreibung

Die Erfindung bezieht sich auf ein Verfahren und eine Vorrichtung zum Bestücken von Substraten mit Bauelementen. Bestückeinrichtungen zum Bestücken von Substraten, insbesondere Leiterplatten, mit elektrischen Bauelementen müssen in der Lage sein, unterschiedliche Substratdicken, Abweichungen in der Substratgeometrie sowie unterschiedliche Dicken der Bauelemente auszugleichen.

Aus US 5 285 946 ist dafür eine Vorrichtung zum Bestücken von elektronischen Bauelementen auf die Oberfläche von Leiterplatten bekannt, bei der eine Saugpipettenspitze als Haltevorrichtung federnd gelagert ist. Diese Federung bewirkt, daß beim Aufsetzen der Bauelemente auf das Substrat bzw. beim Aufsetzen der Saugpipette auf das Bauelement in einer Zuführeinrichtung der nötige Anpreßdruck erreicht wird, ohne durch einen übermäßigen Druck das Bauelement zu zerstören.

Aus der US 5 422 554 ist ebenfalls eine federnd gelagerte Saugpipette als Haltevorrichtung für ein auf ein Substrat aufzusetzendes Bauelement bekannt. Mittels einer mit der Saugpipette mechanisch gekoppelten Feder wird auf ein von der Saugpipette gehaltenes Bauelement beim Aufsetzvorgang auf das Bauelement eine definierte Kraft ausgeübt. Ein mit der Feder mechanisch gekoppeltes steuerbares Stellorgan dient zur genauen Einstellung der Kraft, die beim Aufsetzvorgang durch die Feder auf das Bauelement übertragen werden kann. Somit kann beispielsweise bei verschieden großen Bauelementen die jeweils ausgeübte Anpreßkraft derart verändert werden, daß der entsprechende Anpreßdruck trotz der unterschiedlichen Größe der verschiedenen Bauelemente ungefähr gleich bleibt.

Beim Aufnehmen der Bauelemente aus Zuführeinrichtungen wird beim Anheben eines Bestückkopfes, an dem die Haltevorrichtung federnd gelagert ist, nach der vollständigen Entspannung der Feder eine starke Beschleunigung auf das Bauelement ausgeübt. Die Beschleunigung kann dabei so groß werden, daß das Bauelement von der Haltevorrichtung, beispielsweise einer Saugpipette, abfällt. Derartige verlorene Bauelement führen zum einen dazu, daß der Zyklus der Bestückung wiederholt werden muß, und zum anderen dazu, daß die verlorengegangenen Bauelemente in der Maschine verbleiben und dort Fehler bei der Bewegung der Bestückköpfe oder der Substrate hervorrufen können.

Es ist daher die Aufgabe der Erfindung, ein Verfahren und eine Vorrichtung zum Bestücken von Substraten mit Bauelementen anzugeben, die sowohl ein sicheres Aufnehmen der Bauelemente als auch einen ausreichenden Anpreßdruck der Bauelemente auf das Substrat sicherstellen.

Die Aufgabe wird erfindungsgemäß gelöst durch ein Verfahren mit den Merkmalen des Patentanspruchs 1 sowie durch eine Vorrichtung mit den Merkmalen des Patentanspruchs 2.

Gemäß Anspruch 1 ist dabei entweder vorgesehen, daß die Haltevorrichtung im Moment des Wegbewegens von der Zuführeinrichtung fest mit dem Bestückkopf gekoppelt wird, wodurch die Haltevorrichtung und damit auch das an ihr befindliche Bauelement direkt mit der Beschleunigung der Haltevorrichtung bewegt werden. Alternativ kann beim Wegbewegen von der Zuführeinrichtung das Entspannen der Feder auch gedämpft werden, so daß die maximale Beschleunigung des aufgenommenen Bauelements reduziert wird. Im Moment des Aufsetzens der Haltevorrichtung auf das Bauelement bzw. dem Moment des Aufsetzens des Bauelements auf das Substrat wird durch die federnde Lagerung der Haltevorrichtung gegenüber dem Bestückkopf sichergestellt, daß ein ausreichender Anpreßdruck vorhanden ist, ohne daß das Bauelement bzw. das Substrat durch zu hohen Druck zerstört werden.

Bei der Vorrichtung gemäß Anspruch 2 sind dabei Mittel vorgesehen, um nach einer durch ein Absenken des Bestückkopfes verursachten Spannung der Feder beim Beschleunigen der Haltevorrichtung von der Zuführeinrichtung weg die Entspannung der Feder zumindest zu dämpfen. Auch dadurch ist sichergestellt, daß die Beschleunigung, die auf das Bauelement wirkt, gegenüber der bei einer freischwingenden Feder auftretenden Beschleunigung geringer ist.

Eine besonders einfache Ausgestaltung dieser Mittel ergibt sich nach Anspruch 3 durch Stoßdämpfer, die bei einer Beschleunigung in Richtung von der Zuführeinrichtung weg das Entspannen der Feder dämpfen.

Ebenso gut ist es nach Anspruch 4 vorgesehen, daß die Mittel so ausgebildet sind, daß die Beschleunigung von der Zuführeinrichtung weg direkt auf das dem Bauelement zugewandte Gebiet der Haltevorrichtung wirkt.

Besonders zuverlässig arbeitet die Vorrichtung gemäß Anspruch 5 dadurch, daß die Mittel als von einer Steuereinheit schaltbare Koppelelemente ausgebildet sind, die jeweils in Abhängigkeit von der Position der Haltevorrichtung diese entweder fest mit dem Bestückkopf koppeln (beim Aufnehmen der Bauelemente), bzw. die Haltevorrichtung vom Bestückkopf entkoppeln. Bei entkoppelter Haltevorrichtung wird diese federnd gelagert, so daß der nötige Anpreßdruck der Bauelemente auf dem Substrat erreicht wird.

Die schaltbaren Koppelelemente lassen sich gemäß der Ansprüche 6 bis 10 durch unterschiedliche Prinzipien, wie Vakuumkopplung, Magnetkopplung, Adhäsionskopplung oder mechanische Kopplung realisieren.

Anhand der Figuren der Zeichnungen wird anhand von Ausführungsbeispielen die Erfindung näher erläutert.

Dabei zeigt
Figur 1 eine Seitenansicht einer Haltevorrichtung vor dem Abholen, wobei die Haltevorrichtung nicht eingefedert ist,
Figur 2 eine Seitenansicht einer Haltevorrichtung vor dem Abholen eines Bauelements mit nichtaktiviertem Koppelelement und
Figur 3 eine Seitenansicht einer Haltevorrichtung mit aktiviertem Koppelelement nach dem Abholen eines Bauelements,
Figur 4 eine Seitenansicht einer Haltevorrichtung vor dem Abholen eines Bauelements mit einem Stoßdämpfer und
Figur 5 eine Seitenansicht einer Haltevorrichtung nach dem Abholen mit einem Stoßdämpfer.

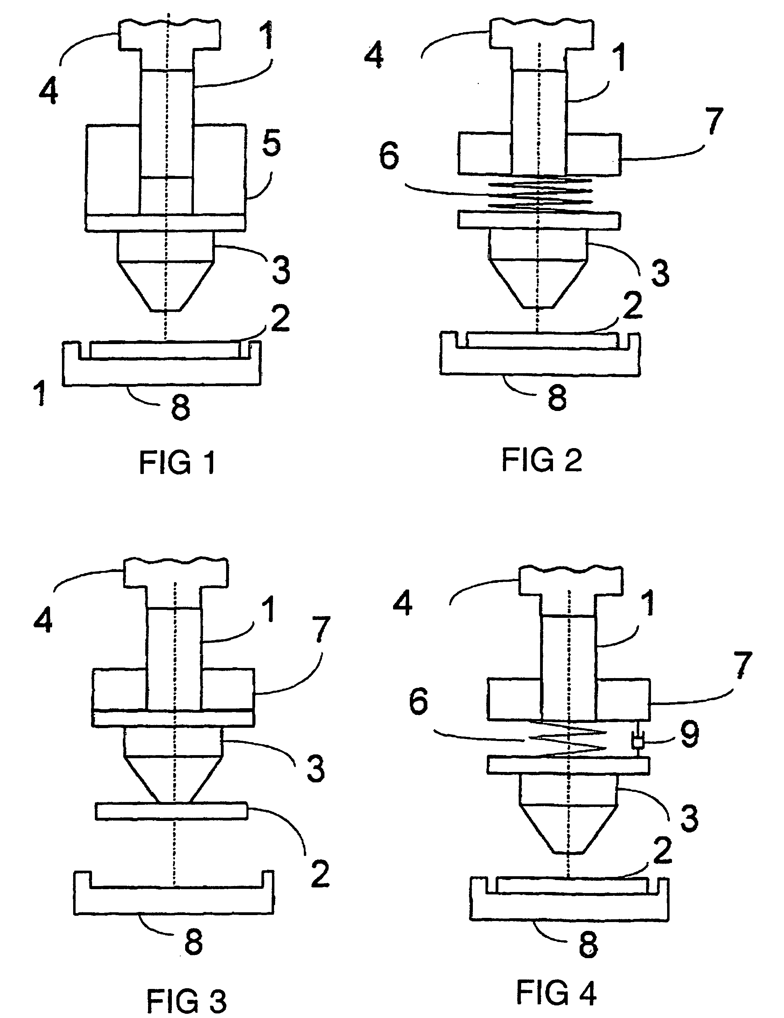

In Figur 1 ist eine Saugpipette 1 als Haltevorrichtung schematisch in Seitenansicht dargestellt, bevor diese ein Bauelement 2 aus einer Zuführeinrichtung 8 abholt. Die Saugpipette 1 hält das Bauelement durch Saugluft. Andere Haltevorrichtungen können Bauelemente 2 beispielsweise durch Adhäsionskräfte halten. Die Saugpipette 1 ist dabei an einem Bestückkopf 4 eines nicht näher dargestellten Bestückautomaten befestigt. Zumindest der dem Bauelement 2 zugewandte Teil der Saugpipette 3 ist dabei über ein Federelement 5 mit dem Bestückkopf 4 verbunden. Beim Aufsetzen der Saugpipette 1 auf das Bauelement 2 bewirkt das Federelement 5 der Saugpipette 1, daß der Anpreßdruck der Saugpipette 1 auf dem Bauelement 2 einen definierten vorgegebenen Wert nicht überschreitet.

In Figur 2 ist ein weiteres Ausführungsbeispiel einer Saugpipette 1 in Seitenansicht dargestellt. Dabei ist das dem Bauelement 2 zugewandte Teil der Saugpipette 3 durch eine Feder 6 mit dem Bestückkopf 4 verbunden. Zusätzlich sind schaltbare Koppelelemente 7 vorgesehen, die in der in Figur 2 dargestellten Position der Saugpipette nicht aktiv sind. Wird nun die Saugpipette 1 auf das Bauelement 2 aufgesetzt, wird durch die Spannung der Feder 6 eine definierter Anpreßdruck erzeugt. Beim Aufnehmen des Bauelementes werden die schaltbaren Koppelelemente 7 aktiviert, wodurch die Feder 6 im zusammengepreßten Zustand verharrt, wie es in Figur 3 dargestellt ist. Dadurch wirkt auf das Bauelement 2 nur die Beschleunigung des Bestückkopfes 4. Bei nachlassender Beschleunigung des Bestückkopfes 4 kann dann die Arretierung 7 wieder gelöst werden. Damit kann das Bauelement in der gewünschten Abseitsposition auf dem Substrat dann wieder unter Einfluß der Feder 6 mit definiertem Anpreßdruck abgesetzt werden.
Die schaltbaren Koppelelemente 7 lassen sich dabei auf der Basis unterschiedlicher an sich bekannter Prinzipien realisieren wie Vakuumkopplung, Adhäsionskopplung, magnetische Kopplung oder mechanische Kopplung. Die mechanische Kopplung ist beispielsweise über ein Piezoelement zu erzielen.

In Figur 4 ist eine Saugpipette 1 mit einem Stoßdämpfer 9 dargestellt, der während des Absetzens der Saugpipette 1 auf dem Bauelement 2 die Federwirkung der Feder 6 höchstens sehr gering dämpft.

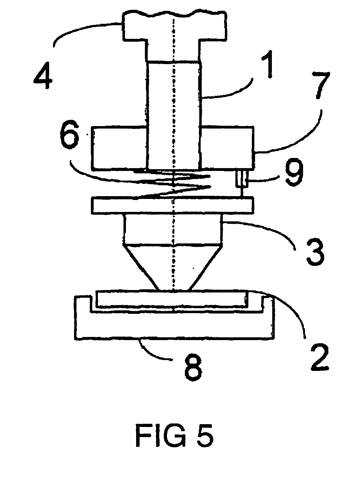

Beim in Figur 5 dargestellten Aufnehmen des Bauelements 2 aus der Zuführeinrichtung 8 bewirkt der Stoßdämpfer 9, daß die Feder 6 nur gedämpft entspannt wird, wodurch das Bauelement 2 in etwa mit der Beschleunigung beaufschlagt wird, mit der auch der Bestückkopf 4 beschleunigt wird. Durch die Dämpfung der Federwirkung wird auch in diesem Ausführungsbeispiel die auf das Bauelement 2 wirkende Beschleunigung reduziert.

Durch die erfindungsgemäße Lösung lassen sich die Saugpipetten mit höherer Beschleunigung betreiben, wodurch mehr Bauelemente in gleicher Zeit aufgenommen werden können, und die Bestückleistung des Bestückautomaten erhöht sich entsprechend.

## Patentansprüche

1. Verfahren zum Bestücken von Substraten mit Bauelementen (2), bei dem
- eine Haltevorrichtung (1), die einem Bestückkopf (4) zugeordnet ist, auf ein in einer Zuführeinrichtung (8) befindliches Bauelement (2) unter Spannung einer Feder (5,6) abgesenkt wird, wobei die Federspannung durch das weitere Absenken des Bestückkopfes (4) nach dem Kontakt der Haltevorrichtung (1) mit dem Bauelement (2) erzeugt wird,
- das Bauelement (2) von der Haltevorrichtung (1) erfaßt wird,
- beim Abheben der Haltevorrichtung (1) das Entspannen der Feder (5,6) verhindert oder zumindest gedämpft wird,
- der Bestückkopf (4) mit der Haltevorrichtung (1) zu einer vorgegebenen Position über dem Substrat verfahren wird,
- das Bauelement (2) unter Spannung der Feder (5,6) auf dem Substrat abgesetzt wird.

2. Vorrichtung zum Bestücken von Substraten mit Bauelementen (2) mit einem Bestückkopf (4) mit mindestens einer Haltevorrichtung (1), von der zumindest der dem Bauelement (2) zugewandte Teil (3) durch eine Feder (6) gegenüber dem Bestückkopf (4) gefedert gelagert ist,
**dadurch gekennzeichnet,**
**daß** Mittel vorgesehen sind, um nach einer durch ein Absenken des Bestückkopfes (4) verursachten Spannung der Feder (6) beim Beschleunigen der Haltevorrichtung (1) von einer Zuführeinrichtung (8) weg die federnde Lagerung zu verhindern oder die Entspannung der Feder (6) zumindest zu dämpfen.

3. Vorrichtung zum Bestücken von Substraten mit Bauelementen (3) nach Anspruch 2,
**dadurch gekennzeichnet,**
**daß** die Mittel als Stoßdämpfer (9) ausgebildet sind, die bei einer Beschleunigung in Richtung von der Zuführeinrichtung (8) weg das Entspannen der Feder (6) dämpfen.

4. Vorrichtung zum Bestücken von Substraten mit Bauelementen (2) nach Anspruch 2,
**dadurch gekennzeichnet,**
**daß** die Mittel so ausgebildet sind, daß die Beschleunigung von der Zuführeinrichtung (8) weg, direkt auf das dem Bauelement (2) zugewandte Gebiet der Haltevorrichtung (3) wirkt.

5. Vorrichtung zum Bestücken von Substraten mit Bauelementen (2) nach Anspruch 4,
**dadurch gekennzeichnet,**
**daß** die Mittel als von einer Steuereinheit schaltbare Koppelelemente (7) ausgebildet sind, die bei der Beschleunigung von der Zuführeinrichtung (8) weg das dem Bauelement (2) zugewandte Gebiet der Haltevorrichtung (3) fest mit dem Bestückkopf (4) koppeln und anschließend wieder entkoppeln.

6. Vorrichtung zum Bestücken von Substraten mit Bauelementen (2) nach Anspruch 5,
**dadurch gekennzeichnet,**
**daß** die schaltbaren Koppelelemente (7) auf der Basis von Vakuumkopplung arbeiten.

7. Vorrichtung zum Bestücken von Substraten mit Bauelementen (2) nach Anspruch 5,
**dadurch gekennzeichnet,**
**daß** die schaltbaren Koppelelemente (7) auf der Basis von Adhäsionskopplung arbeiten.

8. Vorrichtung zum Bestücken von Substraten mit Bauelementen (2) nach Anspruch 5,
**dadurch gekennzeichnet,**
**daß** die schaltbaren Koppelelemente (7) auf der Basis von magnetischer Kopplung arbeiten.

9. Vorrichtung zum Bestücken von Substraten mit Bauelementen (2) nach Anspruch 5,
**dadurch gekennzeichnet,**
**daß** die schaltbaren Koppelelemente (7) auf der Basis von mechanischer Kopplung arbeiten.

10. Vorrichtung zum Bestücken von Substraten mit Bauelementen (2) nach Anspruch 9,
**dadurch gekennzeichnet,**
**daß** die mechanische Kopplung durch ein Piezoelement hervorgerufen wird.

## Claims

1. Method of fitting components (2) on substrates,
in which
- a retaining device (1) , which is assigned to a component-fitting head (4), is lowered, under the stressing of a spring (5, 6), onto a component (2) located in a feed arrangement (8), the spring stressing being produced by the component-fitting head (4) being lowered further following contact of the retaining device (1) with the component (2),
- the component (2) is gripped by the retaining device (1),
- when the retaining device (1) is raised, the action of the spring (5, 6) being relieved of stressing is prevented or at least damped,
- the component-fitting head (4), with the retaining device (1), is displaced to a predetermined position above the substrate,
- the component (2) is set down, under stressing of the spring (5, 6), on the substrate.

2. Device for fitting components (2) on substrates, having a component-fitting head (4) of at least one retaining device (1), of which at least the part (3), which is directed toward the component (2), is mounted resiliently in relation to the component-fitting head (4) by a spring (6),
**characterized in that** means are provided in order, following stressing of the spring (6) caused by the component-fitting head (4) being lowered, to prevent the resilient mounting, or at least to damp the action of the spring (6) being relieved of stressing, during acceleration of the retaining device (1) in the direction away from a feed arrangement (8).

3. Device for fitting components (3) on substrates according to Claim 2, **characterized in that** the means are designed as shock absorbers (9) which, during acceleration in the direction away from the feed arrangement (8), damp the action of the spring (6) being relieved of stressing.

4. Device for fitting components (2) on substrates according to Claim 2, **characterized in that** the means are designed such that the acceleration away from the feed arrangement (8) acts directly on that region of the retaining device (3) which is directed toward the component (2).

5. Device for fitting components (2) on substrates according to Claim 4, **characterized in that** the means are designed as coupling elements (7) which can be switched by a control unit and, during the acceleration away from the feed arrangement (8), couple that region of the retaining device (3) which is directed towards the component (2) firmly to the component-fitting head (4) and then decouple the same again.

6. Device for fitting components (2) on substrates according to Claim 5, **characterized in that** the operation of the switchable coupling elements (7) is based on vacuum coupling.

7. Device for fitting components (2) on substrates according to Claim 5, **characterized in that** the operation of the switchable coupling elements (7) is based on adhesion coupling.

8. Device for fitting components (2) on substrates according to Claim 5, **characterized in that** the operation of the switchable coupling elements (7) is based on magnetic coupling.

9. Device for fitting components (2) on substrates according to Claim 5, **characterized in that** the operation of the switchable coupling elements (7) is based on mechanical coupling.

10. Device for fitting components (2) on substrates according to Claim 9, **characterized in that** the mechanical coupling is brought about by a piezo element.

## Revendications

1. Procédé permettant d'équiper des substrats avec des composants (2), dans lequel
- un dispositif de retenue (1), qui est affecté à une tête à planter (4), est abaissé, sous la tension d'un ressort (5, 6), sur un composant (2) qui se trouve dans un dispositif d'approche (8), la tension du ressort étant produite par la poursuite de la descente de la tête à planter (4) après la prise de contact entre le dispositif de retenue (1 ) et le composant (2),
- le composant (2) est saisi par le dispositif de retenue (1 ),
- lors du relèvement du dispositif de retenue (1), la détente du ressort (5, 6) est empêchée ou, au moins, amortie,
- la tête à planter (4) est déplacée avec le dispositif de retenue (1) vers une position donnée sur le substrat,
- le composant (2) est déposé sur le substrat sous la pression du ressort (5, 6).

2. Dispositif permettant d'équiper des substrats avec des composants (2) et comportant une tête à planter (4) ayant au moins un dispositif de retenue (1), dont au moins la partie (3) tournée vers le composant (2) est montée, grâce à un ressort (6), d'une façon élastique par rapport à la tête à planter (4),
**caractérisé par le fait**
**qu'**il est prévu des moyens destinés à empêcher, après l'apparition d'une tension du ressort (6) produite par un abaissement de la tête à planter (4), lors de l'accélération du dispositif de retenue (1) l'éloignant du dispositif d'approche (8), l'effet élastique du montage ou, au moins, à affaiblir la détente du ressort (6).

3. Dispositif selon la revendication 2 permettant d'équiper des substrats avec des composants (2)
**caractérisé par le fait**
**que** les moyens sont conçus comme absorbeurs de chocs (9), qui amortissent la détente du ressort (6) lors d'une accélération dans le sens qui éloigne du dispositif d'approche (8).

4. Dispositif selon la revendication 2 permettant d'équiper des substrats avec des composants (2)
**caractérisé par le fait**
**que** les moyens sont conçus de telle manière que l'accélération dans le sens qui éloigne du dispositif d'approche (8) agit directement sur la partie du dispositif de retenue (3) tournée vers le composant (2).

5. Dispositif selon la revendication 4 permettant d'équiper des substrats avec des composants (2)
**caractérisé par le fait**
**que** les moyens sont conçus comme éléments de couplage (7) embrayables par une unité de commande, qui, lors de l'accélération dans le sens qui éloigne du dispositif d'approche (8), couplent la zone du dispositif de retenue (3) tournée vers le composant (2) d'une façon fixe avec la tête à planter (4) et la découplent ensuite.

6. Dispositif selon la revendication 5 permettant d'équiper des substrats avec des composants (2)
**caractérisé par le fait**
**que** les éléments de couplage embrayables (7) fonctionnent sur la base d'un couplage sous vide.

7. Dispositif selon la revendication 5 permettant d'équiper des substrats avec des composants (2)
**caractérisé par le fait**
**que** les éléments de couplage embrayables (7) fonctionnent sur la base d'un couplage par adhésion.

8. Dispositif selon la revendication 5 permettant d'équiper des substrats avec des composants (2)
**caractérisé par le fait**
**que** les éléments de couplage embrayables (7) fonctionnent sur la base d'un couplage magnétique.

9. Dispositif selon la revendication 5 permettant d'équiper des substrats avec des composants (2)
**caractérisé par le fait**
**que** les éléments de couplage embrayables (7) fonctionnent sur la base d'un couplage mécanique.

10. Dispositif selon la revendication 9 permettant d'équiper des substrats avec des composants (2)
**caractérisé par le fait**
**que** le couplage mécanique est provoqué par un élément piézo-électrique.
